# EUROPEAN PATENT SPECIFICATION

(11) **EP 1 760 770 B1**
(45) Date of publication and mention of the grant of the patent: **13.10.2010**
(21) Application number: 06016704.6
(22) Date of filing: 10.08.2006
(51) Int. Cl.: H01L 21/316, H01L 21/8246, H01L 27/115, H01L 21/02

(54) **Complex oxide laminate, method of manufacturing complex oxide laminate, and device**
Oxidkomplexlaminat, Verfahren zur Herstellung eines Oxidkomplexlaminats und Vorrichtung
Un stratifié d'oxide complexe, procédé de fabrication d'un stratifié d'oxide complexe et dispositif

(30) Priority: 05.09.2005 JP 2005256416
(43) Date of publication of application: 07.03.2007
(73) Proprietor: Seiko Epson Corporation, Shinjuku-ku Tokyo 163-0811 (JP)
(72) Inventor: Kijima, Takeshi, Suwa-shi Nagano-ken 392-8502 (JP); Ohashi, Koji, Suwa-shi Nagano-ken 392-8502 (JP); Hamada, Yasuaki, Suwa-shi Nagano-ken 392-8502 (JP)
(74) Representative: MERH-IP Matias Erny Reichl Hoffmann

(56) References cited:
- US-A1- 2005 167 712
- KIJIMA T ET AL: "NOVEL SI CODOPED PB(ZR,TI,NB)O3 THIN FILM FOR HIGH-DENSITY FERROELECTRIC RANDOM ACCESS MEMORY" JAPANESE JOURNAL OF APPLIED PHYSICS, JAPAN SOCIETY OF APPLIED PHYSICS, TOKYO, JP, vol. 44, no. 1A, 1 January 2005 (2005-01-01), pages 267-274, XP001245769 ISSN: 0021-4922

## Description

### BACKGROUND OF THE INVENTION

The invention relates to a complex oxide laminate using a Pb-based perovskite oxide, a method of manufacturing the complex oxide laminate, and a device using the complex oxide laminate according to the invention.

A Pb-based perovskite oxide such as PZT (Pb(Zr,Ti)O₃) exhibits excellent ferroelectric characteristics or piezoelectric characteristics. Therefore, the Pb-based perovskite oxide has attracted attention as a ferroelectric film for a ferroelectric memory (see JP-A-2001-139313) or a piezoelectric device (see JP-A-2001-223404).

A complex oxide laminate according to the preamble of claim 1 and a ferroelectric memory using it are known from US 2005/0167712 A1.

### SUMMARY

An object of the invention is to provide a complex oxide laminate exhibiting excellent insulating properties, and a method of manufacturing the complex oxide laminate. Another object of the invention is to provide a device including the above complex oxide laminate.

These objects are achieved by a complex oxide laminate as claimed in claim 1, a method as claimed in claim 6 and a device as claimed in claim 10. Preferred embodiments of the invention are defined in the dependent claims.

In the complex oxide laminate and with the method according to this embodiment, since the specific second complex oxide layer is provided above the first complex oxide layer, crystal defects of the first complex oxide layer can be prevented. Therefore, the complex oxide laminate according to this embodiment exhibits excellent ferroelectric characteristics and piezoelectric characteristics.

According to one embodiment of the invention, there is provided a device comprising the above-described complex oxide laminate.

The device according to this embodiment refers to a device including the above-described complex oxide laminate, and includes a part including the complex oxide laminate and an electronic instrument including the part. Specific examples of the device are described later.

### BRIEF DESCRIPTION OF THE SEVERAL VIEWS OF THE DRAWING

- FIG.1: is a cross-sectional view illustrating a complex oxide laminate according to one embodiment of the invention.
- FIG. 2: illustrates a change in Raman vibration mode of an A-site ion when Si is added to lead titanate in one embodiment of the invention.
- FIG. 3: illustrates lead-containing carboxylic acids used in one embodiment of the invention.
- FIGS. 4A to 4D: illustrate polycarboxylic acids or polycarboxylic acid esters used in one embodiment of the invention.
- FIG. 5: illustrates a formation reaction of a precursor in a precursor composition according to one embodiment of the invention.
- FIG. 6: illustrates a formation reaction of a precursor in a precursor composition according to one embodiment of the invention.
- FIG. 7A: illustrates the hysteresis of a complex oxide laminate of Example 1. and FIG. 7B illustrates the hysteresis of a complex oxide laminate of Comparative Example 1.
- FIG. 8: illustrates changes in polarization of Example 1 and Comparative Example 1.
- FIGS. 9A and 9B: are views illustrating a semiconductor device according to one embodiment of the invention.
- FIG. 10: is a cross-sectional view schematically illustrating a 1T1C ferroelectric memory according to one embodiment of the invention.
- FIG. 11: is a view showing an equivalent circuit of the ferroelectric memory shown in FIG. 10.
- FIG. 12: is a cross-sectional view schematically showing a piezoelectric device according to one embodiment of the invention.
- FIG. 13: is a side cross-sectional view showing a schematic configuration of the inkjet recording head according to one embodiment of the invention.
- FIG. 14: is an exploded perspective view of an inkjet recording head according to one embodiment of the invention.
- FIG. 15: is a perspective view showing an inkjet printer according to one embodiment of the invention.
- FIG. 16: is a cross-sectional view showing a surface acoustic wave device according to one embodiment of the invention.
- FIG. 17: is a perspective view showing a frequency filter according to one embodiment of the invention.
- FIG. 18: is a perspective view showing an oscillator according to one embodiment of the invention.

### DETAILED DESCRIPTION OF THE EMBODIMENT

Some embodiments of the invention will be described in detail below.

### 1. Complex oxide laminate

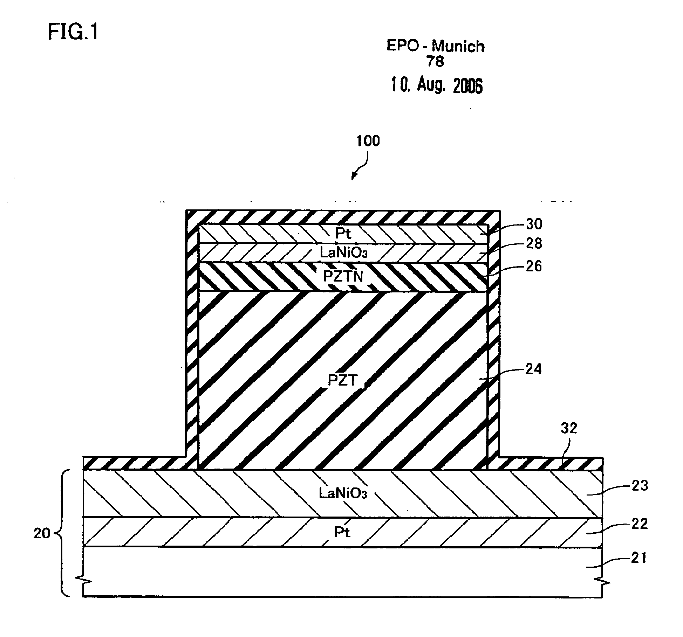

FIG. 1 is a cross-sectional view schematically showing a complex oxide laminate 100 according to one embodiment of the invention.

The complex oxide laminate 100 according to this embodiment includes a substrate 20, a first complex oxide layer 24 of the general formula ABO₃ formed above the substrate 20, and a second complex oxide layer 26 of the general formula AB₁₋ₓCₓO₃ formed above the first complex oxide layer 24. The element A may include at least Pb, the element B may include at least one of Zr, Ti, V, W, and Hf, and the element C may include at least one of Nb and Ta.

As the substrate 20, various substrates may be used depending on the type and application of the complex oxide laminate 100 according to this embodiment. For example, when using the complex oxide laminate 100 as a capacitor of a ferroelectric memory or the like, a substrate including an electrode layer (lower electrode) may be used as the substrate 20. When using the complex oxide laminate 100 as a surface acoustic wave device, a sapphire substrate or the like may be used as the substrate 20.

In the example illustrated in FIG. 1, the complex oxide laminate 100 forms a capacitor and includes an electrode layer. In the substrate 20 of this example, a first electrode layer 22 and a second electrode layer 23 are formed on a base 21 in that order. The first electrode layer 22 is formed of a platinum metal such as platinum, for example. The second electrode layer 23 is formed of a conductive oxide layer having a perovskite structure such as LaNiO₃. The second electrode layer 23 functions as a buffer layer for controlling the crystal orientation of the first complex oxide layer 24. The second electrode layer 23 which functions as the buffer layer allows the first complex oxide layer 24 to be epitaxially grown on the second electrode layer 23. In this case, the first complex oxide layer 24 is grown with the same plane orientation as the second electrode layer 23.

The thicknesses of the first complex oxide layer 24 and the second complex oxide layer 26 are appropriately selected depending on a device to which this embodiment is applied. The first complex oxide layer 24 mainly forms a ferroelectric film or a piezoelectric film of the device. The second complex oxide layer 26 has a function of reducing deterioration of the characteristics of the first complex oxide layer 24. Therefore, the thickness of the second complex oxide layer 26 is set so that the second complex oxide layer 26 at least covers the surface of the first complex oxide layer 24 and absorbs the heterophase formed on the outermost surface of the first complex oxide layer 24. In the example of the capacitor shown in FIG 1, the thickness of the second complex oxide layer 26 may be set at 100 to 1000 nm, for example.

In the first complex oxide layer 24 of the general formula ABO₃ according to this embodiment, the element A may include at least Pb, the element B may include Zr and Ti, and the element C may include Nb. In the second complex oxide layer 26 of the general formula AB₁₋ₓCₓO₃, the element A may include at least Pb, the element B may include Zr and Ti, and the element C may include Nb. In this case, the second complex oxide layer 26 may include Nb in the range of 0.1≤x≤0.3. Specifically, the second complex oxide layer 26 according to this embodiment may be Pb(Zr,Ti,Nb)O₃ (PZTN) in which the Ti site is doped with Nb.

Nb has a size approximately equal to that of Ti (i.e. Nb and Ti have similar ionic radii and have the same atomic radius) and has an atomic weight twice the atomic weight of Ti. Therefore, Nb is not easily released from a lattice even if a collision occurs between atoms due to lattice vibration. Since Nb is stable at a valence of +5, the valence of Pb can be compensated for by Nb⁵⁺ even if Pb is released. Moreover, even if Pb is released during crystallization, it is easier for Nb with a small size to enter the lattice than for O with a large size to be released.

Since Nb⁴⁺ also exists, Nb can replace Ti⁴⁺. In addition, it is considered that Nb is not easily released due to very strong covalent bonding properties (H. Miyazawa, E. Natori, S. Miyashita; Jpn. J. Appl. Phys. 39 (2000) 5679).

Since the second complex oxide layer 26 is formed of PZTN and includes a specific amount of Nb, the second complex oxide layer 26 exhibits excellent composition controllability due to the absence of the adverse effects of a Pb deficiency. As a result, PZTN exhibits excellent hysteresis characteristics, leakage characteristics, reduction resistance, and insulating properties in comparison with PZT.

Nb has been doped into PZT mainly in the Zr-rich rhombohedral region. However, the amount of doping is as small as about 0.2 to 0.025 mol% (J. Am. Ceram. Soc, 84 (2001) 902; Phys. Rev. Let, 83 (1999) 1347). This is because the crystallization temperature is increased when adding a large amount of Nb (e.g. 800°C or more when adding Nb in an amount of 10 mol%).

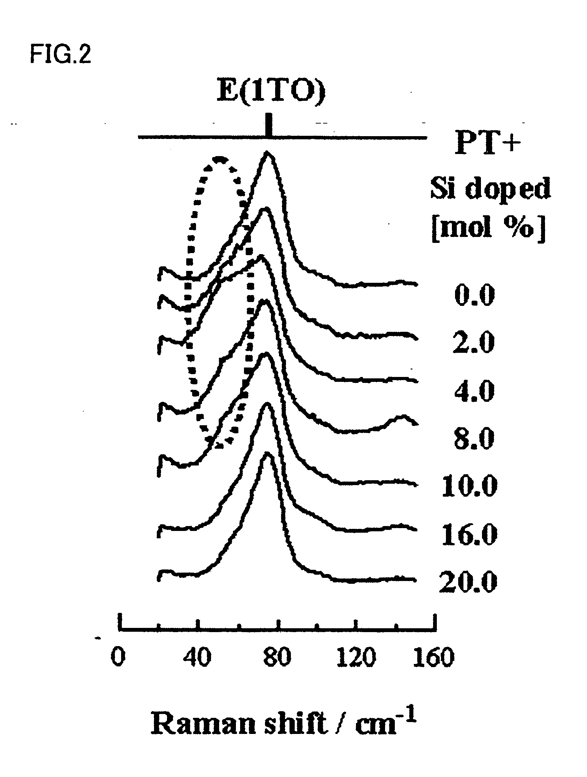

Therefore, it is preferable to add a PbSiO₃ silicate to a precursor composition of the second complex oxide layer 26 in an amount of 0.5 to 10 mol%, for example. This reduces the crystallization energy of PZTN. Specifically, when using PZTN as the material for the complex oxide layer, the crystallization temperature of PZTN can be reduced by adding PbSiO₃ (silicate) in addition to Nb. A silicate and a germanate may be used in combination. The inventors of the invention have confirmed that Si functions as a sintering agent and then forms part of the crystal as the A-site ion (see FIG. 2). Specifically, when adding Si to lead titanate, a change in the Raman vibration mode E (1TO) of the A-site ion was observed, as shown in FIG 2. The change in the Raman vibration mode was observed when adding Si in an amount of 8 mol% or less. Therefore, it was confirmed that Si exists in the A site of the perovskite when adding a small amount of Si.

In this embodiment, Ta may be used instead of Nb, or may be used together with Nb. Ta shows a tendency similar to that of Nb.

As described above, the complex oxide laminate of the general formula AB₁₋ₓCₓO₃ according to this embodiment may include preferably 0.5 mol% or more of at least one of Si and Ge, and still more preferably 0.5 to 10 mol% of Si or Si and Ge.

In this embodiment, a third electrode layer 28 formed of the same material (LaNiO₃) as the second electrode layer 23 and a fourth electrode layer 30 formed of the same material (platinum) as the first electrode layer 22 are provided on the second complex oxide layer 26 in that order. The third electrode layer 28 and the fourth electrode layer 30 form the upper electrode of the capacitor.

The third electrode layer 28 need not necessarily be provided. Note that it is advantageous to provide the third electrode layer 28 since the device is isolated from water in air to exhibit improved reliability.

In this embodiment, a protective layer 32 may be formed on the surface of the complex oxide laminate 100, as required. The protective layer 32 is formed of an insulating film of silicon oxide, silicon nitride, alumina, or the like. The protective layer 32 has a function of preventing the first complex oxide layer 24 and the second complex oxide layer 26 from deteriorating due to a reductive gas (e.g. hydrogen).

In the complex oxide laminate 100 according to this embodiment, the first complex oxide layer 24 exhibits extremely excellent insulating properties, as described later, by forming the specific second complex oxide layer 26 (PZTN layer) on the first complex oxide layer 24 (PZT layer), whereby excellent ferroelectric characteristics and piezoelectric characteristics can be provided.

Specifically, lead and oxygen tend to be released from the PZT layer during heat treatment, whereby deficiencies occur. In particular, since oxygen atoms easily move in comparison with other elements, diffusion of oxygen atoms occurs due to oxygen deficiency. Moreover, Pb, Zr, and Ti of PZT become unstable due to the charge imbalance caused by oxygen deficiency, whereby the diffusion coefficients of these elements increase. On the other hand, crystal defects occur in the PZTN layer to only a small extent. In particular, oxygen deficiency can be prevented. Therefore, diffusion of oxygen in the PZT layer can be reduced. This reduces PZT crystal defects during heat treatment, whereby excellent insulating properties can be maintained.

### 2. Method of manufacturing complex oxide laminate

A method of manufacturing a complex oxide laminate according to one embodiment of the invention includes at least the following steps.
(1) Forming a first complex oxide layer of the general formula ABO₃ above a substrate.
(2) Forming a second complex oxide layer of the general formula AB₁₋ₓCₓO₃ above the first complex oxide layer.

The element A may include at least Pb, the element B may include at least one of Zr, Ti, V, W, and Hf, and the element C may include at least one of Nb and Ta.

The manufacturing method according to this embodiment is described below in detail with reference to FIG 1.

### 2.1. Formation of first complex oxide layer 24

The first complex oxide layer 24 of the general formula ABO₃ is formed on the substrate 20. In the example shown in FIG 1, the first complex oxide layer 22 may be Pb(Zr,Ti)O₃ in which the element A is Pb and the element B is Zr and Ti.

The first complex oxide layer 24 may be epitaxially grown on the substrate 20. In this case, the first complex oxide layer 24 is grown with the same plane orientation as the substrate 20. The substrate 20 may be a single crystal substrate or a substrate in which a buffer layer with crystal controllability is formed on a base, as shown in FIG 1. In the substrate 20 shown in FIG 1, the first electrode layer 22 and the second electrode layer 23 are formed on the base 21 in that order. The first electrode layer 22 is formed of a platinum metal such as platinum, for example. The second electrode layer 23 is formed of a conductive oxide layer having a perovskite structure such as LaNiO₃. The second electrode layer 23 functions as a buffer layer for controlling the crystal orientation of the first complex oxide layer 24. For example, when forming a (100)-oriented first complex oxide layer 24, LaNiO₃, SrRuO₃, or the like may be used for the second electrode layer 23. When forming a (111)-oriented first complex oxide layer 24, a platinum metal such as Pt, Ir, or Ru may be used for the second electrode layer 23. In this case, the first electrode layer 22 may not be provided.

The formation method for the first complex oxide layer 24 is not particularly limited. A known film formation method may be used. As the film formation method, a liquid phase method such as a sol-gel method or an MOD method, or a vapor phase method such as CVD, sputtering, or laser ablation may be used. The first complex oxide layer 24 may be preferably formed using a liquid phase method such as a sol-gel method.

When using the sol-gel method, a sol-gel raw material for forming the first complex oxide layer is applied to the substrate 20. The resulting coating is subjected to heat treatment for drying and cleaning, and then subjected to heat treatment for crystallization. The application and the heat treatment may be repeatedly performed a number of times depending on the thickness of the first complex oxide layer 24. The crystallization heat treatment temperature varies depending on the type and the crystal orientation of the first complex oxide. For example, the crystallization heat treatment temperature for PZT is 650 to 700°C.

### 2.2. Formation of second complex oxide layer 26

The second complex oxide layer 26 may be formed by applying a precursor composition including a precursor for forming an insulating complex oxide of the general formula AB₁₋ₓCₓO₃ and subjecting the applied precursor composition to heat treatment, for example.

The precursor composition and a method of producing the precursor composition are described below in detail.

### 2.2.1. Precursor composition

The precursor composition used in this manufacturing method is used to form the second complex oxide layer 26. The second complex oxide layer may be shown by the general formula AB₁₋ₓCₓO₃, in which the element A may include at least Pb, the element B may include at least one of Zr, Ti, V, W, and Hf, and the element C may include at least one of Nb and Ta. The second complex oxide layer 26 may be shown by the general formula AB₁₋ₓCₓO₃, in which the element A may include Pb, the element B may include Zr and Ti, and the element C may include Nb. In this embodiment, the precursor includes at least the element B and the element C and includes a partial ester bond.

In the precursor composition, the precursor may be dissolved or dispersed in an organic solvent. An alcohol may be used as the organic solvent. The alcohol is not particularly limited. As examples of the alcohol, monohydric alcohols such as butanol, methanol, ethanol, and propanol, and polyhydric alcohols can be given.

Specific examples of the alcohol are given below.

### Monohydric alcohol:

Propanol (propyl alcohol): 1-propanol (boiling point: 97.4°C) and 2-propanol (boiling point: 82.7°C)

Butanol (butyl alcohol): 1-butanol (boiling point: 117°C), 2-butanol (boiling point: 100°C), 2-methyl-1-propanol (boiling point: 108°C), and 2-methyl-2-propanol (melting point: 25.4°C, boiling point: 83°C)

Pentanol (amyl alcohol): 1-pentanol (boiling point: 137°C), 3-methyl-1-butanol (boiling point: 131°C), 2-methyl-1-butanol (boiling point: 128°C), 2,2-dimethyl-1-propanol (boiling point: 113°C), 2-pentanol (boiling point: 119°C), 3-methyl-2-butanol (boiling point: 112.5°C), 3-pentanol (boiling point: 117°C), and 2-methyl-2-butanol (boiling point: 102°C)

### Polyhydric alcohol:

Ethylene glycol (melting point: -11.5°C, boiling point: 197.5°C) and glycerol (melting point: 17°C, boiling point: 290°C)

In the precursor composition, since the precursor includes an ester bond resulting from esterification of a polycarboxylic acid and a metal alkoxide so that a reversible reaction can occur, the polymerized precursor can be decomposed into a metal alkoxide, as described later in detail. Therefore, the metal alkoxide can be recycled as the precursor raw material.

Moreover, the precursor composition used in this embodiment has the following advantages. A commercially available PZT sol-gel solution generally contains lead acetate as the lead raw material. Since lead acetate bonds to an alkoxide of Ti or Zr to only a small extent, lead is not easily incorporated into the precursor network. According to this embodiment, a first carboxyl group, which is one of the two carboxyl groups of succinic acid (dicarboxylic acid) initially functioning as an acid, has a pH of 4.0, which is lower than that of acetic acid (pH=4.56) (i.e. stronger than acetic acid). Therefore, lead acetate is bonded to succinic acid. Specifically, a reaction indicated by "salt of weak acid + strong acid ? salt of strong acid + weak acid" occurs. Since the remaining second carboxyl group of succinic acid is bonded to another MOD molecule or alkoxide, Pb can be easily incorporated into the precursor network.

### 2.2.2. Method of producing precursor composition

The method of producing the precursor composition used in this embodiment includes mixing a sol-gel raw material including at least the element B and the element C and including a hydrolysis-condensation product of a metal alkoxide, a polycarboxylic acid or a polycarboxylic acid ester, and an organic solvent, and forming a precursor including an ester bond formed by esterification of the polycarboxylic acid or a polycarboxylic acid derived from the polycarboxylic acid ester and the metal alkoxide.

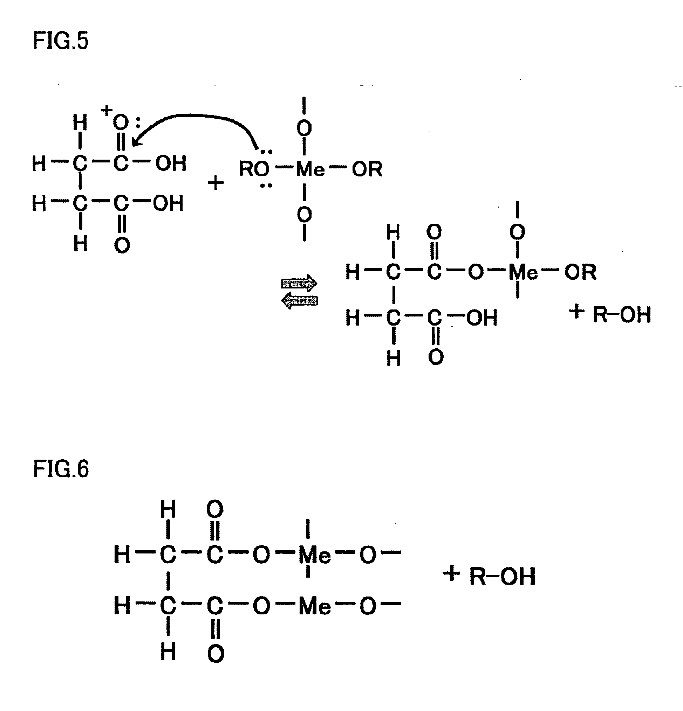

FIGS. 5 and 6 schematically illustrate the precursor formation reaction.

The precursor formation reaction is roughly divided into a first-stage alkoxy group substitution reaction shown in FIG 5, and a second-stage polymer network formation reaction by esterification shown in FIG 6. FIGS. 5 and 6 illustrate an example when using dimethyl succinate as the polycarboxylic acid ester and n-butanol as the organic solvent. Although dimethyl succinate is nonpolar, dimethyl succinate dissociates in an alcohol to produce a dicarboxylic acid.

In the first-stage reaction, dimethyl succinate and the metal alkoxide of the sol-gel raw material undergo esterification and are bonded through an ester bond, as shown in FIG 5. Specifically, dimethyl succinate dissociates in n-butanol so that one of the carbonyl groups (first carbonyl group) is protonated. A substitution reaction occurs between the first carbonyl group and the alkoxyl group of the metal alkoxide to produce a reaction product, in which the first carboxyl group is esterified, together with an alcohol. The term "ester bond" used herein means a bond (-COO-) formed by a carbonyl group and an oxygen atom. The first-stage and second-stage reactions similarly occur in another alcohol.

In the second-stage reaction, a substitution reaction occurs between the remaining carboxyl group (second carboxyl group) and the alkoxyl group of the metal alkoxide to produce a reaction product, in which the second carboxyl group is esterified, together with an alcohol, as shown in FIG 6.

A polymer network, in which the hydrolysis-condensation products of the metal alkoxide included in the sol-gel raw material are bonded through ester bonds, is obtained by the above two-stage reaction. Therefore, the polymer network includes a moderate number of ester bond in the network. Since dimethyl succinate dissociates in two stages and the first carboxyl group has an acid dissociation constant greater than that of the second carboxyl group, the first-stage reaction has a rate of reaction higher than the rate of reaction of the second-stage reaction. Therefore, the second-stage reaction proceeds more slowly than the first-stage reaction.

In this embodiment, the following method may be used to promote the above esterification reaction.
(a) The concentration or reactivity of the reactant may be increased. In more detail, the reactivity is increased by increasing the degree of dissociation of the polycarboxylic acid or the polycarboxylic acid ester by increasing the temperature of the reaction system. It is preferable that the temperature of the reaction system be higher than room temperature and lower than the boiling point of the organic solvent, although the temperature of the reaction system varies depending on the boiling point of the organic solvent. The temperature of the reaction system may be 100°C or less, and preferably 50 to 100°C, for example.
(b) A reaction by-product may be removed. In more detail, esterification is promoted by removing water and an alcohol produced during esterification.
(c) The molecular motion of the reactant may be physically accelerated. In more detail, the reactivity of the reactant is increased by applying energy rays such as ultraviolet rays.

The organic solvent used in the method of producing the precursor composition may be an alcohol, as described above. The sol-gel raw material and the polycarboxylic acid or the polycarboxylic acid ester can be efficiently dissolved by using an alcohol as the solvent.

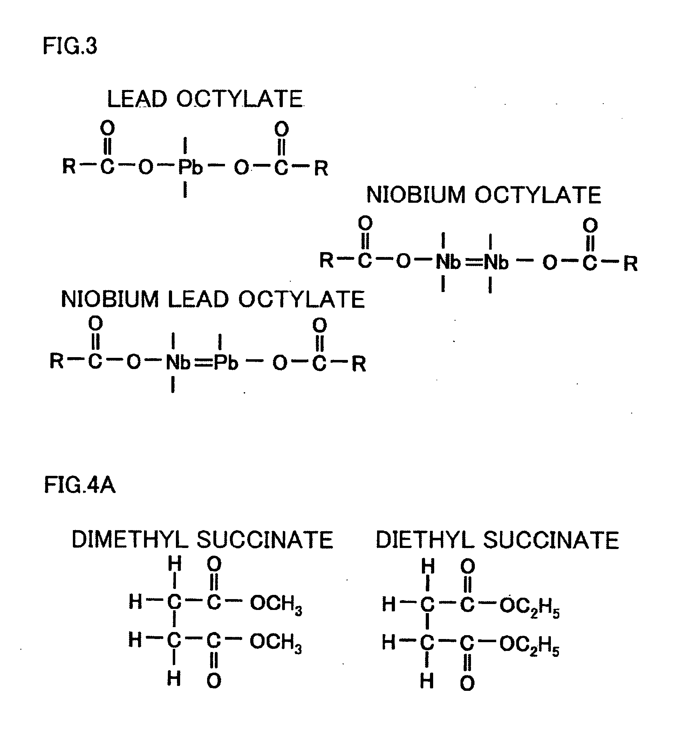

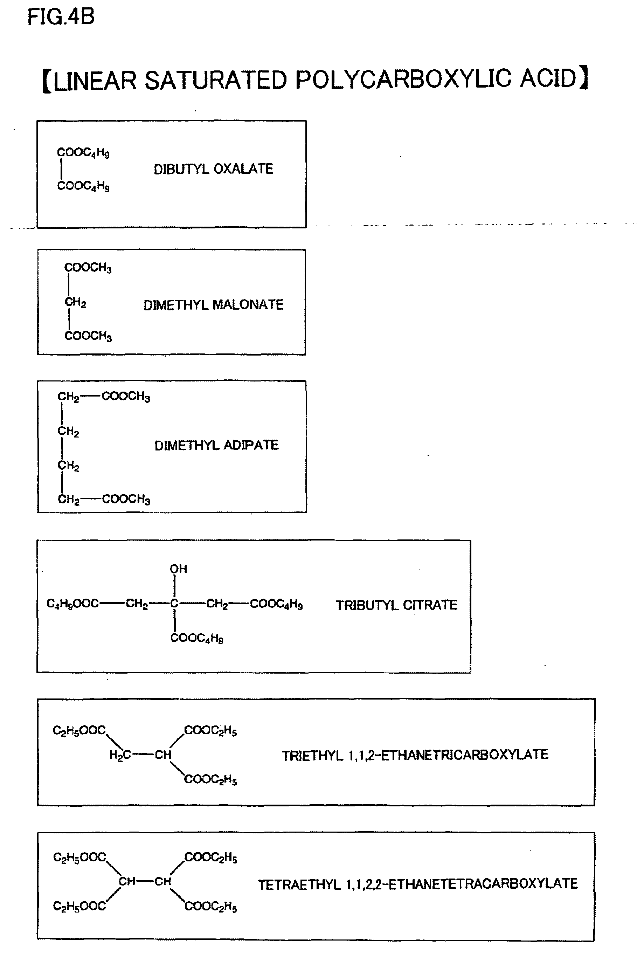

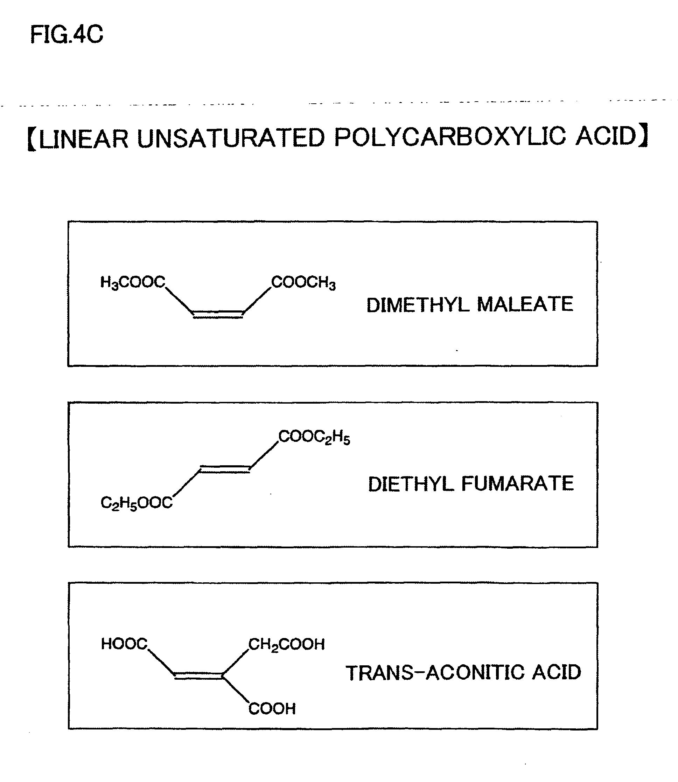

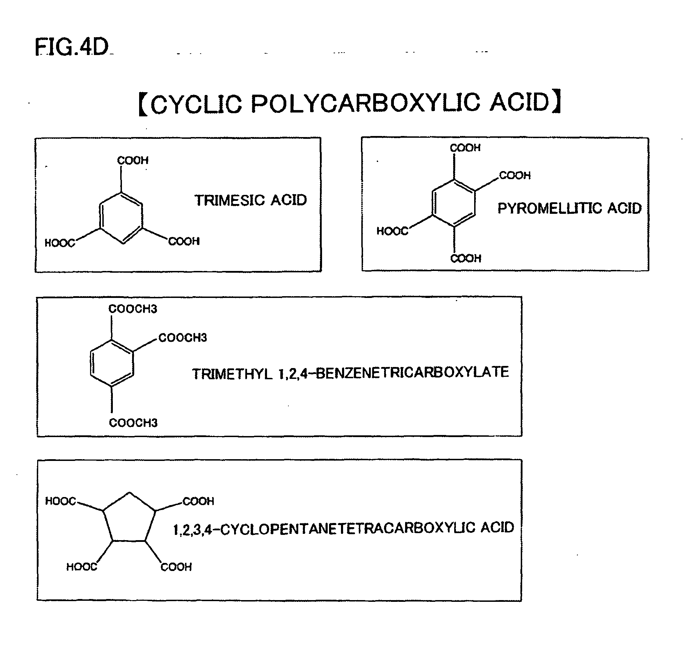

In the method of producing the precursor composition, the polycarboxylic acid or the polycarboxylic acid ester may be a carboxylic acid or a carboxylic acid ester having two or more carboxyl groups. As examples of the polycarboxylic acid used in this embodiment, the following compounds can be given. As examples of a tricarboxylic acid, trans-aconitic acid, trimesic acid, and the like can be given. As examples of a tetracarboxylic acid, pyromellitic acid, 1,2,3,4-cyclopentanetetracarboxylic acid, and the like can be given. As examples of the polycarboxylic acid ester which dissociates in an alcohol to function as a polycarboxylic acid, dicarboxylic acid esters such as dimethyl succinate, diethyl succinate, dibutyl oxalate, dimethyl malonate, dimethyl adipate, dimethyl maleate, and diethyl fumarate, tricarboxylic acid esters such as tributyl citrate and triethyl 1,1,2-ethanetricarboxylate, tetracarboxylic acid esters such as tetraethyl 1,1,2,2-ethanetetracarboxylate and trimethyl 1,2,4-benzenetricarboxylate, and the like can be given. The above polycarboxylic acid ester dissociates in the presence of an alcohol to function as a polycarboxylic acid. FIGS. 4A to 4D illustrate examples of the above-mentioned polycarboxylic acids and polycarboxylic acid esters. This embodiment is characterized in that the network is grown by esterification using the polycarboxylic acid. Since the ester network is not grown when using a monocarboxylic acid or a monocarboxylic acid ester, such as acetic acid or methyl acetate, a monocarboxylic acid or a monocarboxylic acid ester is not used in this embodiment.

In the method of producing the precursor composition, the dicarboxylic acid ester is preferably at least one compound selected from a succinic acid ester, a maleic acid ester, and a malonic acid ester. As specific examples of these esters, dimethyl succinate, dimethyl maleate, and dimethyl malonate can be given.

The polycarboxylic acid ester may have a molecular weight of 150 or less. If the molecular weight of the polycarboxylic acid ester is too great, the resulting film may be damaged when the ester volatilizes during heat treatment, whereby a dense film may not be obtained.

The polycarboxylic acid ester may be liquid at room temperature. If the polycarboxylic acid ester is solid at room temperature, gelation may occur.

The amount of polycarboxylic acid or polycarboxylic acid ester used is adjusted depending on the compositional ratio of the sol-gel raw material and the complex oxide laminate. The ratio of the total molar ion concentration of the PZT sol-gel raw material, PbNb sol-gel raw material, and PbSi sol-gel raw material, to which the polycarboxylic acid is bonded, to the molar ion concentration of the polycarboxylic acid is set at preferably "1 ≥ (molar ion concentration of polycarboxylic acid) / (total molar ion concentration of raw material solution)", and still more preferably 1:1. The polycarboxylic acid may be added in an amount of 0.35 mol, for example.

It is preferable that the amount of polycarboxylic acid or polycarboxylic acid ester added be equal to or greater than the total number of moles of the raw material solution. All the raw materials are bonded when the molar ion concentration ratio is 1:1. However, since an ester stably exists in an acidic solution, it is preferable to add the polycarboxylic acid in excess to the total number of moles of the raw material solution in order to allow an ester to stably exist. The number of moles of the polycarboxylic acid or the polycarboxylic acid ester used herein refers to the number of carboxyl groups. Specifically, when using a dicarboxylic acid or a dicarboxylic acid ester, one dicarboxylic acid or dicarboxylic acid ester molecule can be bonded to two raw material molecules. Therefore, the ratio is 1:1 when the amount of dicarboxylic acid or dicarboxylic acid ester is 0.5 mol for one mol of the raw material solution. The polycarboxylic acid ester does not initially function as an acid. The polycarboxylic acid ester produces a polycarboxylic acid when caused to dissociate in an alcohol. In this case, it is preferable that the number of moles of alcohol added be "1 ≥ (number of moles of alcohol / number of moles of polycarboxylic acid ester)". This is because the polycarboxylic acid ester more sufficiently and stably dissociates as the number of moles of alcohol becomes greater. The number of moles of alcohol used herein refers to a molar ion concentration obtained by dividing the number of moles by the number of hydroxyl groups.

In the method of producing the precursor composition, a raw material including a metal carboxylate may be additionally used. As examples of the metal carboxylate, the above-mentioned lead carboxylate such as lead acetate and lead octylate can be given.

In the method of producing the precursor composition, an organometallic compound (MOD raw material) may be used together with the sol-gel raw material. As the organometallic compound, niobium octylate or the like may be used. As shown in the FIG. 3, niobium octylate has a structure in which two Nb atoms form a covalent bond and an octyl group exists in the remaining site. In this case, since a network other than the two Nb atoms does not exist, niobium octylate is regarded as the MOD raw material.

A network is formed between the carboxylic acid and the MOD raw material mainly through an alcohol exchange reaction. When using niobium octylate, a reaction occurs between the carboxylic acid and the octyl group (alcohol exchange reaction), whereby esterification (R-COO-Nb) proceeds. According to this embodiment, the molecules of the MOD raw material can be bonded to the precursor network through condensation between the MOD raw material and the alkoxide by esterifying the MOD raw material, as described above.

In the method of producing the precursor composition according to this embodiment, a sol-gel raw material including Si or Si and Ge may be used as the sol-gel raw material including the hydrolysis-condensation product of the metal alkoxide. As such a sol-gel solution, a PbSiO₃ sol-gel solution may be individually used, or a PbSiO₃ sol-gel solution and a PbGeO₃ sol-gel solution may be used in combination. The crystallization temperature can be reduced by using the sol-gel raw material including Si or Ge.

In the method of producing the precursor composition according to this embodiment, PZTN may be obtained by using a solution prepared by mixing at least a PbZrO₃ sol-gel solution, a PbTiO₃ sol-gel solution, and a PbNbO₃ sol-gel solution as the sol-gel solution. In this case, the above-mentioned sol-gel raw material including Si or Si and Ge may also be mixed.

When introducing Ta instead of Nb, a PbTaO₃ sol-gel solution may be used as the sol-gel raw material.

Since the precursor of the precursor composition obtained according to this embodiment includes a moderate number of ester bonds between the molecular networks, a reversible reaction can occur. Therefore, the polymerized precursor (polymer network) can be decomposed into the metal alkoxide condensate by causing the reaction shown in FIG 5 to occur in the left direction.

The method of producing the precursor composition and the precursor composition used in this embodiment have the following features.

According to the method of producing the precursor composition, a polymer network in which the hydrolysis-condensation products (molecular networks) of the metal alkoxide of the sol-gel raw material are bonded through ester bonds is obtained in the organic solvent by using the polycarboxylic acid. Therefore, the polymer network includes a moderate number of ester bonds between the molecular networks derived from the above hydrolysis-condensation products. The esterification reaction can be easily carried out by controlling the temperature and the like.

Since the precursor composition includes a moderate number of ester bonds between the molecular networks, a reversible reaction can occur. Therefore, the polymerized precursor (polymer network) can be decomposed into the metal alkoxide (or molecular network of its condensation product) in the composition remaining after forming the complex oxide laminate film. Since the metal alkoxide (or molecular network of its condensation product) can be recycled as the precursor raw material, a toxic substance such as lead can be recycled. Therefore, it is advantageous from the viewpoint of environmental protection.

### 2.3. Formation of upper electrode

When using the complex oxide laminate according to this embodiment as a capacitor, an upper electrode is formed on the second complex oxide layer 26. In the example shown in FIG 1, the third electrode layer 28 is formed on the second complex oxide layer 26, and the fourth electrode layer 30 is formed on the third electrode layer 28. The third electrode layer 28 may be formed of a conductive complex oxide layer having a perovskite structure in the same manner as the second complex oxide layer 26. As the material for the third electrode layer 28, LaNiO₃ may be used in the same manner as the second electrode layer 23, for example. As the material for the fourth electrode layer 30, a platinum metal such as Pt may be used in the same manner as the first electrode layer 22, for example. The third electrode layer 28 may be formed by laser ablation, sputtering, CVD, or the like. The fourth electrode layer 30 may be formed by sputtering or the like.

When using the first and second complex oxide layers 24 and 26 for a surface acoustic wave device, an interdigital transducer (IDT electrode) having a specific pattern may be formed on the second complex oxide layer 26.

### 2.4. Formation of capacitor

When using the complex oxide laminate according to this embodiment as a capacitor, the first and second complex oxide layers 24 and 26 and the third and fourth electrode layers 28 and 30 are patterned by known lithography and etching.

The protective layer 30 of an oxide (silicon oxide), nitride (silicon nitride), alumina, or the like may be formed using a known method (e.g. CVD) on the exposed surfaces of the substrate 20, the complex oxide layers 24 and 26, and the electrode layers 28 and 30, as required.

The manufacturing method according to this embodiment exhibits the following effects by forming the second complex oxide layer 26 on the first complex oxide layer 24. Specifically, crystal defects of the PZTN layer can be reduced and diffusion of atoms of the PZT layer can be prevented by forming the second complex oxide layer (e.g. PZTN layer) 26 on the first complex oxide layer (e.g. PZT layer) 24. As a result, the complex oxide laminate according to this embodiment does not show deterioration of the insulating properties of the PZT layer and exhibits excellent ferroelectric characteristics and piezoelectric characteristics.

The above effects are described below in detail taking an example of combining the PZTN layer 24 and the PZTN layer 26.

In the complex oxide layer, crystal defects tend to be concentrated on the uppermost portion of the layer. In particular, although PZT is suitable for device applications due to a low crystallization temperature of about 500°C, a lead deficiency tends to occur in the uppermost portion of the layer due to the high vapor pressure of lead (Pb). When a lead deficiency has occurred, an oxygen deficiency also occurs according to the charge neutrality principle (Schottky defects). As a result, PZT exhibits a large leakage current. Therefore, since an electric field applied to the PZT layer during piezoelectric driving tends to be released as a large leakage current, the actual piezoelectric constant cannot be increased. When a high electric field is continuously applied to the PZT layer without taking the leakage current into consideration, the PZT layer generates heat due to the leakage current and eventually breaks. As described above, while it is relatively easy to obtain an excellent PZT crystal film due to the low crystallization temperature, a large leakage current tends to occur due to the heterophase containing a lead deficiency and an oxygen deficiency occurring in the upper portion of the PZT layer. This makes it difficult to obtain a PZT layer with a large piezoelectric constant. Therefore, although it is theoretically advantageous to reduce the film thickness of the PZT complex oxide to about one micrometer in order to obtain a large piezoelectric constant, PZT has been used as a film (bulk) with a thickness of 10 micrometers or more taking the large leakage current into consideration.

On the other hand, PZTN is a complex oxide which can prevent an oxygen deficiency, even if defects have occurred due to the high vapor pressure of lead, by utilizing the high covalent bonding properties of polyvalent niobium. As a result, PZTN exhibits a leakage current about 1/10,000th that of PZT. This has been confirmed by the inventor of the invention. On the other hand, PZTN tends to exhibit a crystallization temperature higher to some extent than that of PZT.

In this embodiment, the advantages of PZT and PZTN are combined while compensating for the disadvantages of PZT and PZTN. For example, a PZT crystal layer with a large thickness (e.g. one micrometer) is initially formed. In this case, since PZT has a low crystallization temperature, it is relatively easy to obtain an excellent PZT crystal film. A thin PZTN layer (e.g. 100 nm) is then formed in the uppermost layer. The PZTN layer can be crystallized at a low temperature through epitaxial growth by effectively utilizing the crystal orientation of PZT. During crystallization, the PZTN layer absorbs the heterophase in the uppermost portion of the PZT layer. Since the PZTN layer is a ceramic which rarely produces a heterophase, as described above, a heterophase rarely occurs in the uppermost portion of the laminate. As a result, the complex oxide laminate according to this embodiment exhibits excellent insulating properties to exhibit excellent ferroelectric characteristics and piezoelectric characteristics, as is clear from the examples described later.

### 3. Examples

Examples according to the invention will be described below. Note that the invention is not limited to the following examples.

### 3.1. Example 1

A complex oxide laminate according to Example 1 was obtained as follows. In Example 1, a PZT layer was used as the first complex oxide layer, and a PZTN layer was used as the second complex oxide layer. The reference numerals of the members are the same as those shown in FIG 1.

### 3.1.1. Formation of first complex oxide layer

A substrate 20 was provided in which a Pt layer (first electrode layer) 22 with a thickness of 90 nm and an LaNiO₃ layer (second electrode layer) 23 with a thickness of 60 nm were formed on a silicon substrate (base) 21 in that order. The Pt layer and the LaNiO₃ layer were formed by sputtering.

A PZT first complex oxide layer (hereinafter called "PZT layer") 24 was formed on the substrate 20 using a known sol-gel method. A precursor composition used in this step was obtained as follows.

In this example, the precursor composition for the PZT layer was prepared using first and second raw material solutions containing at least one of Pb, Zr, and Ti. As the first raw material solution, a solution was used in which a polycondensation product for forming a PbZrO₃ perovskite crystal containing Pb and Zr was dissolved in n-butanol in an anhydrous state. As the second raw material solution, a solution was used in which a polycondensation product for forming a PbTiO₃ perovskite crystal containing Pb and Ti was dissolved in n-butanol in an anhydrous state.

When forming a PbZr_{0.52}Ti_{0.48}O₃ (PZT) complex oxide layer using the first and second raw material solutions, the raw material solutions were mixed at a ratio of "(first raw material solution)/(second raw material solution) = 52/48".

The resulting sol-gel raw material was applied to the substrate 20 by spin coating. The resulting coating was dried at 150 to 180°C and subjected to cleaning heat treatment at 300 to 350°C. The coating was sintered at 650°C by RTA to obtain a PZT layer with a thickness of 100 nm.

The above steps including coating formation, drying, cleaning heat treatment, and sintering were repeatedly performed ten times to form a PZT layer with a thickness of about one micrometer.

### 3.1.2. Formation of second complex oxide layer

A precursor composition was prepared. A PZTN second complex oxide layer (hereinafter called "PZTN layer") 26 was formed using the precursor composition. The precursor composition used in this step was obtained as follows.

Specifically, the precursor composition for forming the PZTN film was obtained by mixing first to third raw material solutions respectively containing at least one of Pb, Zr, Ti, and Nb, dimethyl succinate as a polycarboxylic acid ester, and n-butanol as an organic solvent. The mixed solution was prepared by dissolving the sol-gel raw material and dimethyl succinate in n-butanol at a ratio of 1:1.

As the first raw material solution, a solution was used in which a polycondensation product for forming a PbZrO₃ perovskite crystal containing Pb and Zr was dissolved in n-butanol in an anhydrous state.

As the second raw material solution, a solution was used in which a polycondensation product for forming a PbTiO₃ perovskite crystal containing Pb and Ti was dissolved in n-butanol in an anhydrous state.

As the third raw material solution, a solution was used in which a polycondensation product for forming a PbNbO₃ perovskite crystal containing Pb and Nb was dissolved in n-butanol in an anhydrous state.

When forming a PbZr_{0.33}Ti_{0.47}Nb_{0.2}O₃ (PZTN) complex oxide layer using the first, second, and third raw material solutions, the raw material solutions are mixed at a ratio of "(first raw material solution):(second raw material solution):(third raw material solution) = 33:47:20". In order to reduce the crystallization temperature of the ferroelectric layer, a solution prepared by dissolving a polycondensation product for forming a PbSiO₃ crystal in n-butanol in an anhydrous state was added to the above mixed solution as a fourth raw material solution in an amount of 2 mol% to obtain a precursor composition.

The resulting precursor composition was applied to the first complex oxide layer 24 by spin coating. The resulting coating was dried at 150 to 180°C and subjected to cleaning heat treatment at 300 to 350°C. The coating was sintered at 700°C by RTA to obtain a PZTN layer with a thickness of about 100 nm.

### 3.1.3. Formation of upper electrode and protective layer

An LaNiO₃ layer (third electrode layer) 28 with a thickness of 60 nm and a Pt layer (fourth electrode layer) 30 with a thickness of 50 nm were formed on the second complex oxide layer (PZTN layer) 24 by sputtering. The fourth electrode layer 30, the third electrode layer 28, the second complex oxide layer 26, and the first complex oxide layer 24 were patterned by known lithography and dry etching to form a capacitor. A protective layer (silicon oxide layer) 32 was then formed by CVD using trimethylsilane.

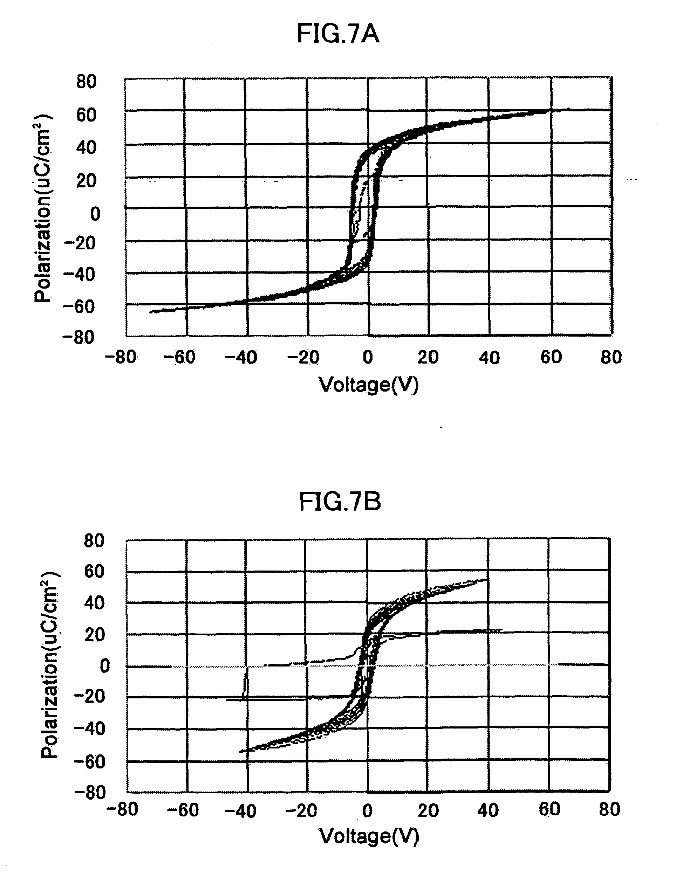

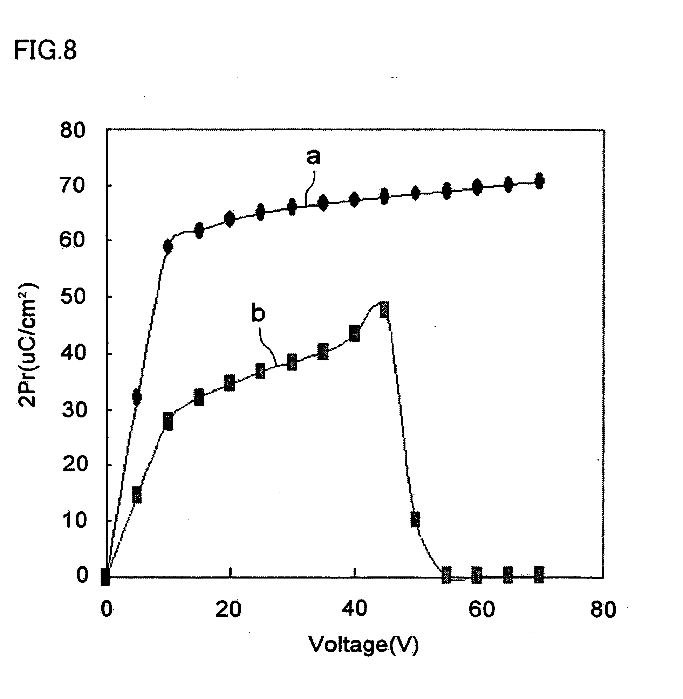

The hysteresis of the capacitor of Example 1 thus obtained was determined. The results are shown in FIG 7A. The symbol a in FIG 8 indicates the relationship between the voltage and polarization (2Pr) determined for the capacitor of Example 1.

As shown in FIG 7A, it was confirmed that the capacitor of Example 1 exhibits excellent ferroelectric characteristics and excellent hysteresis. As shown in FIG 8, it was confirmed that the capacitor of Example 1 exhibits a stable and large polarization over a wide voltage range.

### 3.2. Comparative Example 1

A comparative capacitor was obtained in the same manner as in Example 1 except that the second complex oxide layer 26 was not formed. The hysteresis of the comparative capacitor was determined. The results are shown in FIG 7B. As shown in FIG 7B, it was confirmed that the comparative capacitor does not show hysteresis characteristics at a specific voltage.

The symbol b in FIG 8 indicates the relationship between the voltage and polarization (2Pr) determined for the comparative capacitor of Comparative Example 1. As shown in FIG 8, it was confirmed that the capacitor of Comparative Example 1 shows a small polarization in comparison with the capacitor of Example 1. It was also confirmed that the capacitor breaks at a voltage higher than about 50 V to lose ferroelectric characteristics.

As described above, it was confirmed that the capacitor of Example 1 including the PZTN layer provided on the PZT layer exhibits excellent insulating properties and ferroelectric characteristics in comparison with the capacitor of Comparative Example 1 which does not include the PZTN layer. The remanent polarization of Example 1 was about twice that of Comparative Example 1. Since the remanent polarization is proportional to the piezoelectric constant, a large piezoelectric constant which is about twice that of Comparative Example 1 is obtained according to Example 1.

### 4. Device

A device according to one embodiment of the invention includes a part including the above-described complex oxide laminate and an electronic instrument including the part. Examples of the device are described below.

### 4.1. Semiconductor device

A semiconductor device including the complex oxide laminate is described below. This embodiment illustrates an example of a ferroelectric memory device including a ferroelectric capacitor which is an example of the semiconductor device.

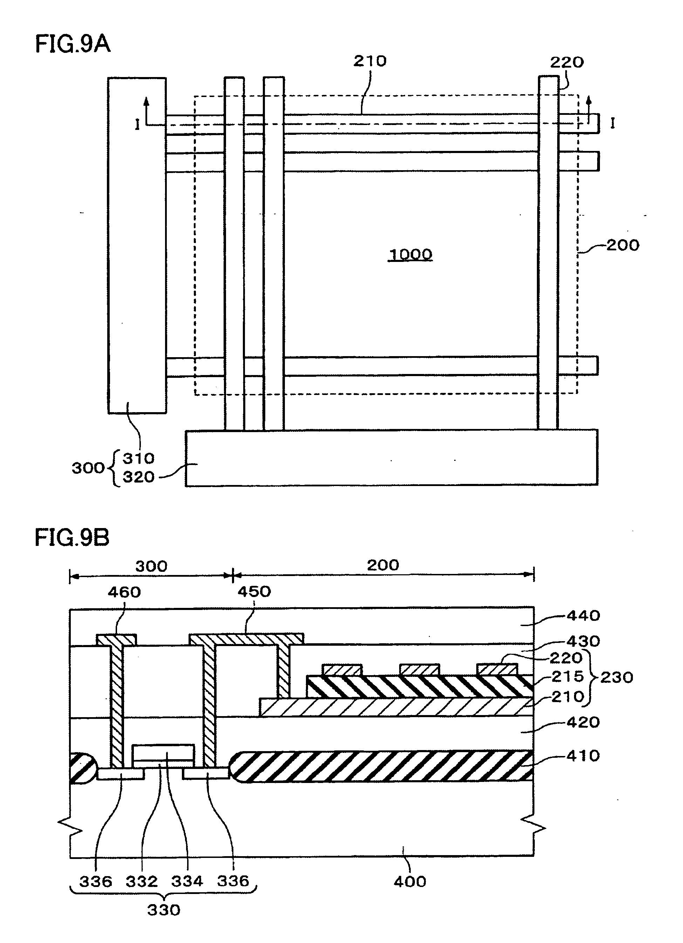

FIGS. 9A and 9B are views schematically showing a ferroelectric memory device 1000 having the complex oxide laminate. FIG 9A shows the planar shape of the ferroelectric memory device 1000, and FIG 9B shows the cross section along the line I-I in FIG 9A.

As shown in FIG. 9A, the ferroelectric memory device 1000 includes a memory cell array 200 and a peripheral circuit section 300. In the memory cell array 200, row-select lower electrodes 210 (wordlines) and column-select upper electrodes 220 (bitlines) are arranged to intersect. The lower electrodes 210 and the upper electrodes 220 are formed in the shape of stripes formed of linear signal electrodes. The signal electrodes may be formed so that the lower electrode 210 serves as the bitline and the upper electrode 220 serves as the wordline. The peripheral circuit section 300 includes various circuits for selectively writing or reading information into or from the memory cell array 200. For example, the peripheral circuit section 300 includes a first driver circuit 310 for selectively controlling the lower electrode 210, a second driver circuit 320 for selectively controlling the upper electrode 220, and a signal detection circuit (not shown) such as a sense amplifier.

As shown in FIG 9B, a ferroelectric film 215 is disposed between the lower electrodes 210 and the upper electrodes 220. In the memory cell array 200, a memory cell which functions as a ferroelectric capacitor 230 is formed in the region in which the lower electrode 210 intersects the upper electrode 220. The ferroelectric capacitor 230 is formed of the above complex oxide laminate 100. Specifically, the ferroelectric film 215 is formed using the first and the second complex oxide layers 24 and 26. It suffices that the ferroelectric film 215 be disposed at least in the region in which the lower electrode 210 (e.g. first and second electrode layers 22 and 23 shown in FIG 1) intersects the upper electrode 220 (e.g. third and fourth electrode layers 28 and 30 shown in FIG 1).

As shown in FIG 9B, the peripheral circuit section 300 includes a MOS transistor 330 formed on the semiconductor substrate 400. The MOS transistor 330 includes a gate insulating film 332, a gate electrode 334, and source/drain regions 336. The MOS transistors 330 are isolated by an element isolation region 410. The first interlayer dielectric 420 is formed on the semiconductor substrate 400 on which the MOS transistor 330 is formed. The peripheral circuit section 300 is electrically connected with the memory cell array 200 through an interconnect layer 51. In the ferroelectric memory device 1000, a second interlayer dielectric 430 and an insulating protective layer 440 are formed.

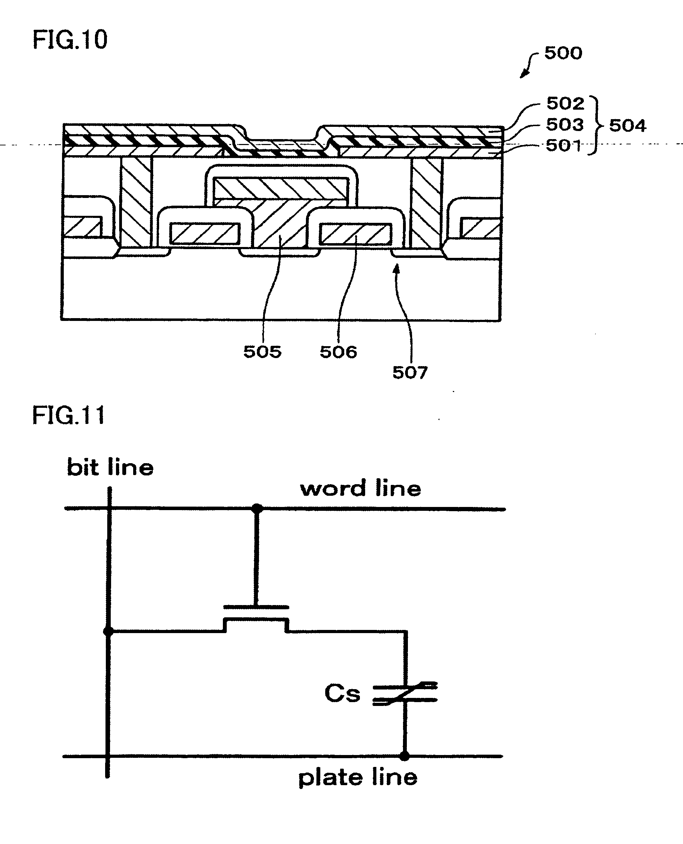

FIG 10 is a structural diagram of a 1T1C ferroelectric memory device 500 as another example of the semiconductor device. FIG. 11 is an equivalent circuit diagram of the ferroelectric memory device 500.

As shown in FIG 10, the ferroelectric memory device 500 is a memory device having a structure similar to that of a DRAM, and includes a capacitor 504 (1C) including a lower electrode 501, an upper electrode 502 connected with a plate line, and a ferroelectric film 503 (the first and second complex oxide layers 24 and 26) according to the above-described embodiment, and a switch transistor element 507 (1T) including source/drain electrodes, one of which is connected with a data line 505, and a gate electrode 506 connected with a wordline. In the 1T1C memory, data can be written and read at a speed as high as 100 ns or less, and the written data does not volatilize. Therefore, the 1T1C memory is a promising memory which may replace an SRAM or the like.

Since the semiconductor device according to this embodiment is formed using the raw material solution according to the above embodiment, the ferroelectric film can be crystallized at a low temperature. Therefore, the semiconductor device can be embedded together with a semiconductor element such as a MOS transistor. The semiconductor device according to this embodiment is not limited to the above-described semiconductor devices. The semiconductor device according to this embodiment may also be applied to a 2T2C ferroelectric memory device and the like.

### 4.2. Piezoelectric device

An example in which the above complex oxide laminate is applied to a piezoelectric device is described below.

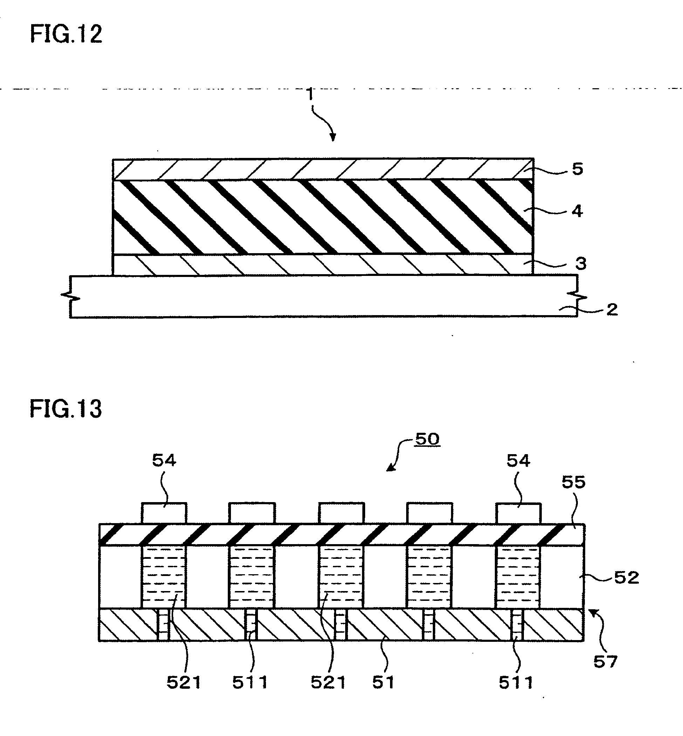

FIG 12 is a cross-sectional view showing a piezoelectric device 1 including the above complex oxide laminate. The piezoelectric device 1 includes a substrate 2, a lower electrode 3 formed on the substrate 2, a piezoelectric film 4 formed on the lower electrode 3, and an upper electrode 5 formed on the piezoelectric film 4. The piezoelectric film 4 is formed using the first and the second complex oxide layers 24 and 26.

The substrate 2 includes a (110)-oriented single crystal silicon substrate and a thermal oxide film formed on the surface of the single crystal silicon substrate. The substrate 2 is processed to form ink cavities 521 in an inkjet recording head 50, as described later (see FIG 13).

### 4.3. Inkjet recording head

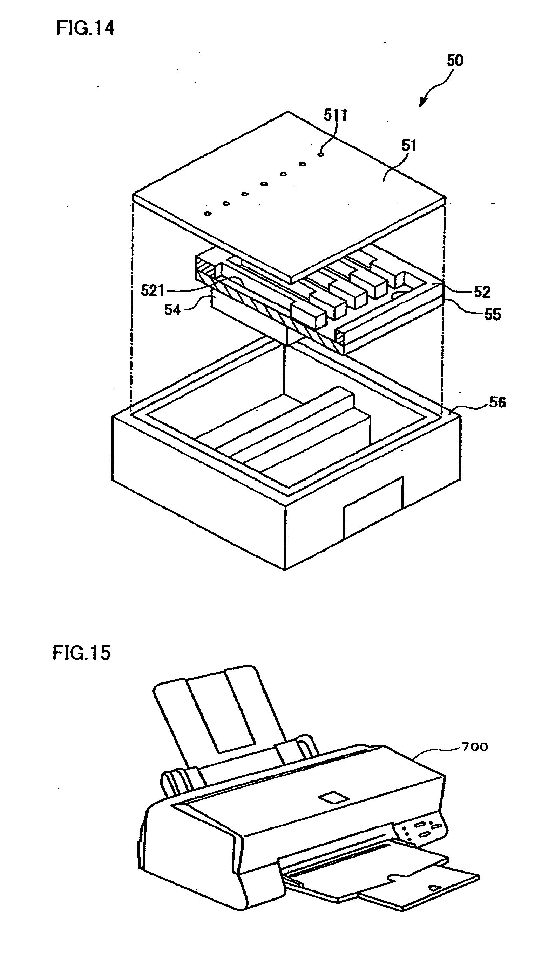

An inkjet recording head in which the above-described piezoelectric device functions as a piezoelectric actuator, and an inkjet printer including the inkjet recording head are described below. FIG 13 is a side cross-sectional view showing a schematic configuration of the inkjet recording head according to this embodiment, and FIG 14 is an exploded perspective view of the inkjet recording head which is illustrated in a vertically reversed state. FIG 15 shows an inkjet printer 700 including the inkjet recording head according to this embodiment.

As shown in FIGS. 13 and 14, the inkjet recording head 50 includes a head body (base) 57 and a piezoelectric section 54 formed over the head body 57. The piezoelectric device 1 shown in FIG 12 is provided in the piezoelectric section 54. The piezoelectric device 1 is formed by stacking the lower electrode 3, the piezoelectric film (ferroelectric film) 4, and the upper electrode 5 in that order. The piezoelectric film 4 is a film formed using the above complex oxide laminate. In the inkjet recording head, the piezoelectric section 54 functions as a piezoelectric actuator.

The head body (base) 57 includes a nozzle plate 51, an ink chamber substrate 52, and an elastic film 55. These members are accommodated in a housing 56 to form the inkjet recording head 50.

The piezoelectric section is electrically connected with a piezoelectric device driver circuit (not shown) and is actuated (vibrate or deformed) based on a signal from the piezoelectric device driver circuit. Specifically, the piezoelectric section 54 functions as a vibration source (head actuator). The elastic film 55 vibrates due to vibration (deflection) of the piezoelectric section 54, and functions to momentarily increase the pressure inside the cavity 521.

An example of the inkjet recording head which discharges ink is described above. However, this embodiment aims at a liquid jet head using a piezoelectric device and a liquid jet device in general. As the liquid jet head, a recording head used for an image recording device such as a printer, a color material jet head used for a color filter for a liquid crystal display or the like, an electrode material jet head used for an electrode of an organic EL display, a field emission display (FED), or the like, a bio-organic substance jet head used for a bio-chip, and the like can be given.

### 4.4. Surface acoustic wave device

An example of a surface acoustic wave device to which the above-described complex oxide laminate is applied is described below with reference to the drawings.

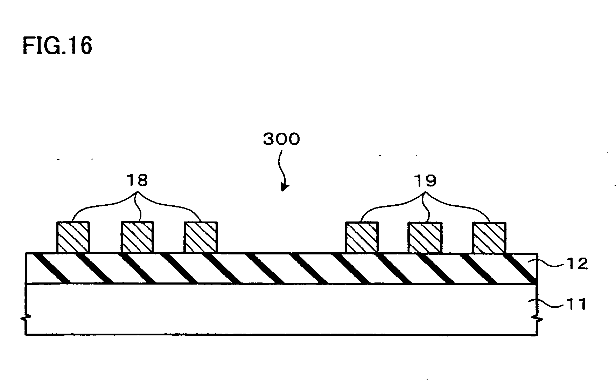

FIG 16 is a cross-sectional view schematically showing a surface acoustic wave device 300 according to this embodiment.

The surface acoustic wave device 300 includes a substrate 11, a piezoelectric film 12 formed on the substrate 11, and interdigital transducers (hereinafter called "IDT electrodes") 18 and 19 formed on the piezoelectric film 12. The IDT electrodes 18 and 19 have a specific pattern. The piezoelectric film 12 is formed by using the first and second complex oxide layers 24 and 26.

The surface acoustic wave device 300 according to this embodiment is formed as described below by using a piezoelectric film laminate, for example.

The first and second complex oxide layers 24 and 26 shown in FIG. 1 are formed on the substrate 11 shown in FIG 16 to form the piezoelectric film 12. A conductive film is then formed on the piezoelectric film 12. The IDT electrodes 18 and 19 are formed on the piezoelectric film 12 by patterning the conductive film by using a known lithography technology and etching technology.

### 4.5. Frequency filter

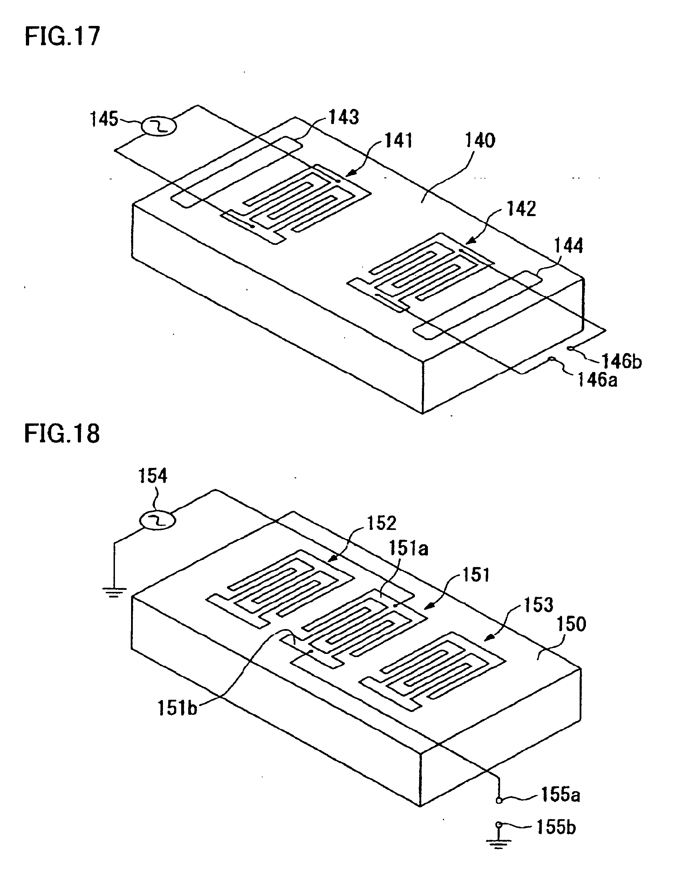

An example of a frequency filter to which the complex oxide laminate is applied is described below with reference to the drawings. FIG 17 is a view schematically showing the frequency filter according to this embodiment.

As shown in FIG 17, the frequency filter includes a base 140. As the base 140, a laminate similar to that of the above-described surface acoustic wave device 300 may be used (see FIG 16).

IDT electrodes 141 and 142 are formed on the upper side of the base 140. Sound absorbing sections 143 and 144 are formed on the upper side of the base 140 so that the IDT electrodes 141 and 142 are positioned between the sound absorbing sections 143 and 144. The sound absorbing sections 143 and 144 absorb surface acoustic waves propagated on the surface of the base 140. A high-frequency signal source 145 is connected with the IDT electrode 141, and signal lines are connected with the IDT electrode 142. The piezoelectric film may be formed by using the complex oxide laminate.

### 4.6. Oscillator

An example of an oscillator to which the complex oxide laminate is applied is described below with reference to the drawings. FIG. 18 is a view schematically showing the oscillator according to this embodiment.

As shown in FIG 18, the oscillator includes a base 150. As the base 150, a laminate (see FIG. 16) similar to that of the above-described surface acoustic wave device 300 may be used.

An IDT electrode 151 is formed on the upper side of the base 150, and IDT electrodes 152 and 153 are formed so that the IDT electrode 151 is positioned between the IDT electrodes 152 and 153. A high-frequency signal source 154 is connected with a comb-shaped electrode 151a forming the IDT electrode 151, and a signal line is connected with the other comb-shaped electrode 151b. The IDT electrode 151 corresponds to an electrode for applying an electric signal, and the IDT electrodes 152 and 153 correspond to electrodes for causing a specific frequency component or a frequency component in a specific band of surface acoustic waves generated by the IDT electrode 151 to resonate. The piezoelectric film may be formed by using the complex oxide laminate.

The above-described oscillator may be applied to a voltage controlled SAW oscillator (VCSO).

As described above, the frequency filter and the oscillator according to this embodiment include the above-described surface acoustic wave device having a high electromechanical coupling factor. Therefore, this embodiment allows a reduction in the size of the frequency filter and the oscillator.

The invention is not limited to the above-described embodiments, and various modifications can be made. For example, the invention includes various other configurations substantially the same as the configurations described in the embodiments (in function, method and result, or in objective and result, for example). The invention also includes a configuration in which an unsubstantial portion in the described embodiments is replaced. The invention also includes a configuration having the same effects as the configurations described in the embodiments, or a configuration able to achieve the same objective. Further, the invention includes a configuration in which a publicly known technique is added to the configurations in the embodiments.

Although only some embodiments of the invention have been described in detail above, those skilled in the art will readily appreciate that many modifications are possible in the embodiments without materially departing from the novel teachings and advantages of this invention. Accordingly, all such modifications are intended to be included within the scope of this invention.

## Claims

1. A complex oxide laminate comprising:
a substrate (20); and
a first complex oxide layer (24) represented by a general formula ABO₃ formed above the substrate (20), wherein element A includes Pb, and element B includes Zr and Ti;
**characterized in that**
a second complex oxide layer (26) represented by a general formula AB₁₋ₓCₓO₃ is formed above the first complex oxide layer (24), wherein element C includes Nb and x is in the range of 0.1≤x≤0.3.

2. The complex oxide laminate as defined in claim 1, wherein the second complex oxide layer (26) further includes at least one of Si and Ge in an amount of 0.5 mol% or more.

3. The complex oxide laminate as defined in claim 1 or 2, wherein the second complex oxide layer (26) has a thickness smaller than that of the first complex oxide layer (24).

4. The complex oxide laminate as defined in any one of claims 1 to 3, wherein the substrate (20) includes an electrode layer (22, 23).

5. The complex oxide laminate as defined in any one of claims 1 to 4, further comprising a buffer layer (23) used for controlling the crystal orientation of the first complex oxide layer (24) and formed under the first complex oxide layer (24).

6. A method of manufacturing a complex oxide laminate, comprising:
forming a first complex oxide layer (24) represented by a general formula ABO₃ above a substrate (20), wherein element A includes Pb, and element B includes Zr and Ti; and **characterized by**
forming a second complex oxide layer (26) represented by a general formula AB₁₋ₓCₓO₃ above the first complex oxide layer (24), wherein element C includes Nb and x is in the range of 0.1≤x≤0.3.

7. The method of claim 6, wherein the second complex oxide layer (26) is formed by applying a precursor composition including a precursor for forming an insulating complex oxide represented by the general formula AB₁₋ₓCₓO₃ and by subjecting the applied precursor composition to a heat treatment.

8. The method of claim 7, wherein the precursor composition includes a precursor which includes at least the element B and the element C and has a partial ester bond.

9. The method of manufacturing a complex oxide laminate as defined in claim 7 or 8, wherein the precursor further includes at least one of Si and Ge.

10. A device comprising the complex oxide laminate as defined in any one of claims 1 to 5

## Patentansprüche

1. Komplexer Oxidverbundstoff, der aufweist:
ein Substrat (20); und
eine erste komplexe Oxidschicht (24), die durch eine allgemeine Formel ABO₃ repräsentiert wird, ausgebildet auf dem Substrat (20), wobei das Element A Pb umfasst und das Element B Zr und Ti umfasst;
**dadurch gekennzeichnet, dass**
eine zweite komplexe Oxidschicht (26), die durch eine allgemeine Formel AB₁₋ₓCₓO₃ repräsentiert wird, auf der ersten komplexen Oxidschicht (24) ausgebildet ist, wobei das Element C Nb umfasst und x in dem Bereich von 0,1≤ x ≤ 0,3 liegt.

2. Komplexer Oxidverbundstoff gemäß Anspruch 1, wobei die zweite komplexe Oxidschicht (26) weiter zumindest eines aus Si und Ge in einer Menge von 0,5 mol% oder mehr umfasst.

3. Komplexer Oxidverbundstoff gemäß Anspruch 1 oder 2, wobei die zweite komplexe Oxidschicht (26) eine Dicke hat, die geringer ist als die der ersten komplexen Oxidschicht (24).

4. Komplexer Oxidverbundstoff gemäß einem der Ansprüche 1 bis 3, wobei das Substrat (20) eine Elektrodenschicht (22, 23) umfasst.

5. Komplexer Oxidverbundstoff gemäß einem der Ansprüche 1 bis 4, der weiter eine Pufferschicht (23) aufweist, die zum Steuern der Kristallorientierung der ersten komplexen Oxidschicht (24) verwendet wird und unter der ersten komplexen Oxidschicht (24) ausgebildet ist.

6. Verfahren zur Herstellung eines komplexen Oxidverbundstoffs, das aufweist:
Bilden einer ersten komplexen Oxidschicht (24), die durch eine allgemeine Formel ABO₃ repräsentiert wird, auf einem Substrat (20), wobei das Element A Pb umfasst und das Element B Zr und Ti umfasst;
und **gekennzeichnet durch**
Bilden einer zweiten komplexen Oxidschicht (26), die **durch** eine allgemeine Formel AB₁₋ₓCₓO₃ repräsentiert wird, auf der ersten komplexen Oxidschicht (24), wobei das Element C Nb umfasst und x in dem Bereich von 0,1≤ x ≤ 0,3 liegt.

7. Verfahren gemäß Anspruch 6, wobei die zweite komplexe Oxidschicht (26) gebildet wird durch Anwenden einer Präkursorverbindung mit einem Präkursor zum Bilden eines isolierenden komplexen Oxids, repräsentiert durch die allgemeine Formel AB₁₋ₓCₓO₃, und durch Unterziehen der angewendeten Präkursorverbindung einer Wärmebehandlung.

8. Verfahren gemäß Anspruch 7, wobei die Präkursorverbindung einen Präkursor umfasst, der zumindest das Element B und das Element C umfasst und eine teilweise Esterbindung hat.

9. Verfahren zur Herstellung eines komplexen Oxidverbundstoffs gemäß Anspruch 7 oder 8, wobei der Präkursor weiter zumindest eines aus Si und Ge umfasst.

10. Vorrichtung, die den komplexen Oxidverbundstoff gemäß einem der Ansprüche 1 bis 5 aufweist.

## Revendications

1. Stratifié d'oxyde complexe comprenant :
un substrat (20) ; et
une première couche (24) d'oxyde complexe, représentée par une formule générale ABO₃, formée au-dessus du substrat (20), l'élément A comprenant du Pb, et l'élément B comprenant du Zr et du Ti ;
**caractérisé en ce que**
une seconde couche (26) d'oxyde complexe, représentée par la formule générale AB₁₋ₓCₓO₃, est formée au-dessus de la première couche (24) d'oxyde complexe, l'élément C comprenant du Nb et x étant dans l'intervalle de 0,1≤x≤0,3.

2. Stratifié d'oxyde complexe tel que défini à la revendication 1, dans lequel la deuxième couche (26) d'oxyde complexe comprend, en outre, au moins l'un de Si et de Ge en une quantité supérieure ou égale à 0,5 % en mole.

3. Stratifié d'oxyde complexe tel que défini à la revendication 1 ou 2, dans lequel la deuxième couche (26) d'oxyde complexe a une épaisseur plus petite que celle de la première couche (24) d'oxyde complexe.

4. Stratifié d'oxyde complexe tel que défini à l'une quelconque des revendications 1 à 3, dans lequel le substrat (20) comprend une couche (22, 23) formant une électrode.

5. Stratifié d'oxyde complexe tel que défini à l'une quelconque des revendications 1 à 4, comprenant, en outre, une couche (23) tampon utilisée pour se rendre maître de l'orientation cristalline de la première couche (24) d'oxyde complexe et formée sous la première couche (24) d'oxyde complexe.

6. Procédé de fabrication d'un stratifié d'oxyde complexe, dans lequel :
on forme une première couche (24) d'oxyde complexe, représentée par une formule générale ABO₃, au-dessus d'un substrat (20), l'élément A comprenant du Pb, et l'élément B comprenant du Zr et du Ti ; et **caractérisé en ce que**
on forme une deuxième couche (26) d'oxyde complexe, représentée par une formule générale AB₁₋ₓCₓO₃, au-dessus de la première couche (24) d'oxyde complexe, l'élément C comprenant du Nb et x étant dans l'intervalle de 0,1≤x≤0,3.

7. Procédé suivant la revendication 6, dans lequel on forme la deuxième couche (26) d'oxyde complexe en appliquant une composition de précurseur, comprenant un précurseur pour former un oxyde complexe isolant, représenté par la formule générale AB₁₋ₓCₓO₃, et en soumettant la composition de précurseur appliquée à un traitement thermique.

8. Procédé suivant la revendication 7, dans lequel la composition de précurseur comprend un précurseur qui comprend au moins l'élément B et l'élément C et a une liaison d'ester partielle.

9. Procédé de fabrication d'un stratifié d'oxyde complexe tel que défini à la revendication 7 ou 8, dans lequel le précurseur comprend, en outre, au moins l'un de Si et de Ge.

10. Dispositif comprenant le stratifié d'oxyde complexe tel que défini suivant l'une quelconque des revendications 1 à 5.
